# EUROPEAN PATENT APPLICATION

(11) **EP 4 261 884 A2**
(43) Date of publication of application: **18.10.2023**
(21) Application number: 23162799.3
(22) Date of filing: 20.03.2023
(51) Int. Cl.: H01L 23/544

(54) **BACK SIDE TO FRONT SIDE ALIGNMENT ON A SEMICONDUCTOR WAFER WITH SPECIAL STRUCTURES**

(30) Priority: 21.03.2022 US 202217699650
(71) Applicant: Infineon Technologies AG, 85579 Neubiberg (DE)
(72) Inventor: OFFENBERG, Dirk, 01139 Dresden (DE)
(74) Representative: Lambsdorff & Lange Patentanwälte Partnerschaft mbB

(57) **Abstract**

A method of aligning a lithographic layer on a semiconductor wafer comprises forming, in a first side of the semiconductor wafer, a first alignment structure from one or more first trenches. In some embodiments, the trenches are formed to a depth reaching to within about three micrometers from the second side of the semiconductor wafer, for example. In others, the wafer is thinned after the first alignment structure is formed, so that the trenches then reach to within about three micrometers from the second side of the semiconductor wafer. At least one lithographic layer is aligned on a second side of the semiconductor wafer by detecting the first alignment structure from the second side, using illumination in the visible spectrum.

## Description

### TECHNICAL FIELD

The present disclosure is generally related to the fabrication of semiconductor devices and is more specifically related to techniques for aligning lithographic layers used on the front and back sides of the semiconductor wafer from which the semiconductor devices are formed.

### BACKGROUND

In many cases, semiconductor devices are formed from processes that are performed only on a single side of a semiconductor wafer. However, the production of other devices may involve processes formed on both sides of the wafer, i.e., on the "top" and "bottom" sides. For example, this can be the case when fabricating image-sensor devices that use backside illumination, where wafer processing steps are performed on both sides of the wafer.

In this latter situation, features formed in or on the top side may need to be aligned, sometimes with great precision, with features formed in or on the bottom side. More particularly, for a given process step, a lithographic mask used to define a feature in or on one side of the semiconductor wafer may need to be aligned with features previously formed in or on the other side of the wafer.

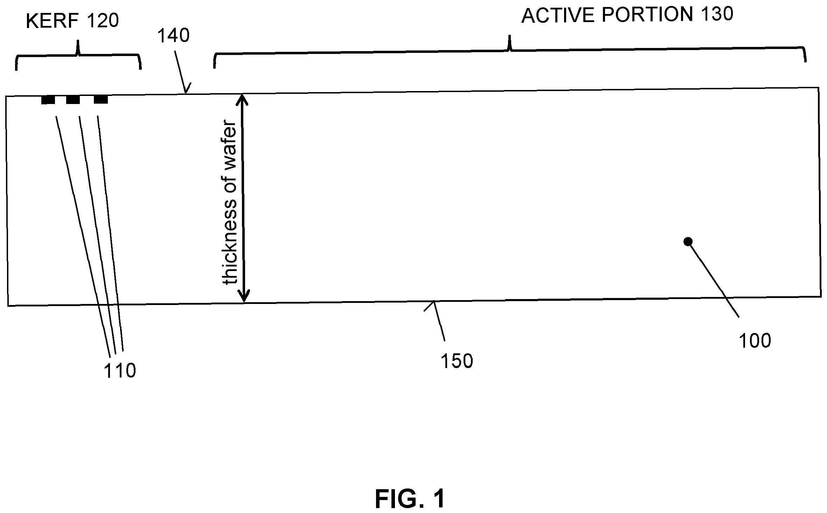

Alignment systems align a lithographic layer to a previously formed feature optically, typically using illumination with a wavelength from about 560 nanometers (nm) to 630 nm. Figure 1 provides a simplified illustration of a portion of a semiconductor wafer 100, with alignment structures 110 formed in a kerf portion 120 of the semiconductor wafer 100, on a first side 140. Devices are formed in and on the semiconductor wafer 100 in an active portion 130 of the semiconductor wafer; these devices might include, for instance, a pixel array for an image sensor device. The term "active portion" is used herein to refer to portions of the semiconductor wafer in which semiconductor devices that will be active when the devices are in use are formed. If the lithographic layer is being aligned to alignment structures 110 on the same side 140 of the semiconductor wafer 100, alignment using light visible to the human eye works well. But aligning a lithographic layer to features on the opposite side 150 of a silicon semiconductor wafer is difficult, due to the limited penetration into the wafer of the light used for alignment.

Depending on the light's wavelength and the doping of the silicon, the transparency of the semiconductor wafer can be low, such that an alignment system might only be able to detect alignment features through a few micrometers of silicon. However, many devices, such as infrared (IR) sensors and time-of-flight (TOF) sensors, need silicon films considerably thicker than this, to provide adequate sensitivity. Accordingly, improved techniques for aligning lithographic layers to features on the opposite side of a semiconductor wafer are needed.

### SUMMARY

An example method of aligning a lithographic layer on a semiconductor wafer according to several of the embodiments described herein comprises forming, in a first side of the semiconductor wafer, a first alignment structure from one or more first trenches. In some embodiments according to this method, the trenches are formed to a depth reaching to within about 3 micrometers from the second side of the semiconductor wafer, for example. In others, the wafer is thinned after the first alignment structure is formed, so that the trenches then reach to within about 3 micrometers from the second side of the semiconductor wafer. At least one lithographic layer is aligned on a second side of the semiconductor wafer by detecting the first alignment structure from the second side, using illumination in the visible spectrum.

Another example method of aligning a lithographic layer on a semiconductor wafer according to several of the embodiments described also includes forming, in a first side of the semiconductor wafer, a first alignment structure from one or more first trenches. This second example method further comprises the step of depositing an epitaxial layer on the first side of the semiconductor wafer, after said forming of the first alignment structure, such that a bottom side of said epitaxial layer overgrows the one or more first trenches, leaving corresponding cavities between the semiconductor wafer and the epitaxial layer. This second example method still further includes the step of thinning the semiconductor wafer from a side opposite the first side, after said depositing, thereby forming a second side, to at least a thickness where the cavities are detectable from the second side of the semiconductor wafer using illumination in the visible spectrum. Finally, this second example method includes the step of aligning at least one lithographic layer on the second side of the semiconductor wafer by detecting the cavities from the second side, using illumination in the visible spectrum.

Additional details and several variations of the above-summarized examples are provided in the detailed description that follows and illustrated in the attached figures.

### BRIEF DESCRIPTION OF THE FIGURES

Figure 1 illustrates a conventional alignment structure formed on a first side of a semiconductor wafer.
Figure 2 illustrates the formation of an alignment structure in a first side of a semiconductor wafer, for use in aligning one or more lithographic layers on a second side of the semiconductor wafer, according to some embodiments of the presently disclosed techniques.
Figure 3 illustrates the formation of an alignment structure in a first side of a semiconductor wafer, for use in aligning one or more lithographic layers on a second side of the semiconductor wafer, according to some embodiments of the presently disclosed techniques.
Figure 4 illustrates the formation of "zero layer" structures in a first side of a semiconductor wafer, according to some of the presently disclosed techniques.
Figure 5 illustrates the deposition of an epitaxial layer atop the semiconductor wafer of Figure 4.
Figure 6 illustrates additional top-side processing on the semiconductor wafer and epitaxial layer of Figure 5.
Figure 7 illustrates the direct bonding of a silicon wafer atop the structure of Figure 6.
Figure 8 illustrates the thinning of the semiconductor wafer of Figures 4-7, from a bottom side, according to some embodiments of the presently disclosed techniques.
Figure 9 is a process flow diagram illustrating an example method according to several of the presently disclosed techniques.
Figure 10 is another process flow diagram illustrating an example method according to some of the presently disclosed techniques.

### DETAILED DESCRIPTION

As discussed above, typical alignment systems using illumination with a wavelength from about 560 nanometers (nm) to 630 nm align a lithographic layer to a previously formed feature optically, typically. If the lithographic layer is being aligned to features on the same side of the semiconductor wafer, this works well. But aligning a lithographic layer to features on the opposite side of the semiconductor wafer is difficult, due to the limited penetration into the silicon wafer of the light used for alignment.

Note that in the present discussion, the terms "lithographic layer" and "lithographic mask" are generally used as interchangeable. A lithographic layer may be understood as referring to the pattern formed in or on a semiconductor using a patterned lithographic mask. When speaking of alignment, aligning a lithographic layer to a previously formed feature is achieved by aligning the corresponding lithograph mask; thus, when the phrase "aligning a lithographic layer" is used, this implies "aligning a lithographic mask."

In the discussion that follows, several of the detailed examples are described in the context of processing a silicon semiconductor wafer, in some cases for use in producing sensor devices. The inventive techniques described, however, are not limited to either silicon wafers or to the fabrication of any particular type of semiconductor device.

In the discussion that follows, the term "trench" is frequently used. This term should be understood broadly, to refer to any depression, slot, or groove that is intentionally introduced into a surface of a semiconductor wafer. These trenches may be formed using etching processes, but the term "trench" is not limited to trenches so formed - other techniques, such as laser ablation, might be used to form a trench.

One approach to addressing the problems that arise when attempting to align a lithographic layer applied to one side of a semiconductor to features on the opposite side of the semiconductor wafer is change the wavelength of the illumination used for the alignment system. For instance, a wavelength between about 980 nm and about 1200 nm might be used, to obtain better penetration through silicon. However, this requires a change in both the illumination source and detectors in the alignment system. Converting an existing system to this new wavelength can be expensive.

The several techniques described herein address this problem by forming alignment marks which are visible, using conventional alignment systems, on both sides of the semiconductor wafer. While these techniques have several features in common, the techniques detailed below can be divided into three primary categories.

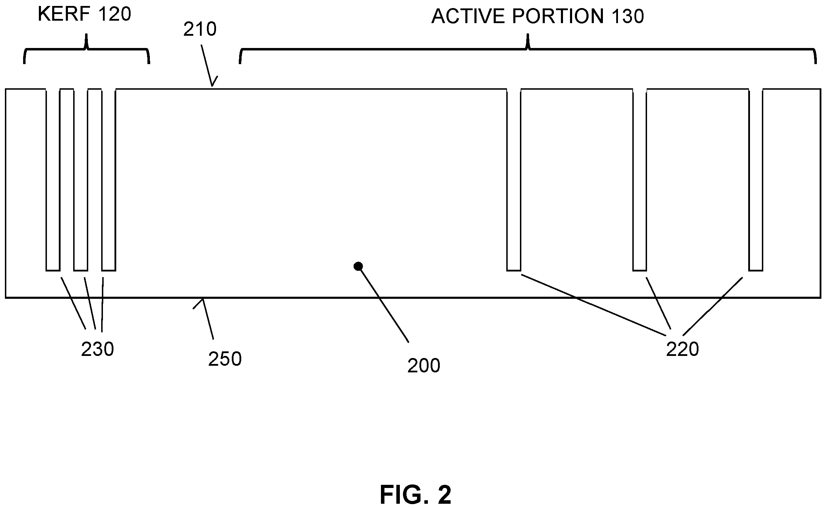

A first category is especially suitable when deep trenches in the semiconductor wafer are needed for some purpose, e.g., to reduce cross-talk from one portion of a semiconductor device to another. Figure 2 illustrates an example of this first category of techniques. In the illustrated example, deep trenches 220 are formed in a first side 210 of the semiconductor wafer 200; this first side 210 might be regarded as the "front" side. The same process steps used to form these deep trenches 220 (e.g., exposure, etching, stripping, etc.) may be used to also form alignment structures 230 in the first side of the wafer; these alignment structures 230 may be interchangeably called alignment marks, and may comprise one, a few, or several trenches. These alignment marks 230 may be used to align one or more lithographic layers subsequently applied to the first side 210 of the wafer 200. These same alignment marks 230 may also be used, however, when later aligning lithographic layers on the second side 250 of the semiconductor wafer 200, which might be considered the "back" side.

As can be seen in Figure 2, with this approach the silicon wafer's thickness is reduced where the trenches 220 and alignment structures 230 are formed, to an extent that the bottoms of the alignment structures 230 are visible, using conventional illumination, from the second side 250 of the wafer 200. Thus, alignment marks 230 formed from one or more of these trenches may be used to align lithographic layers on either side of the semiconductor wafer 200. Note that an advantage of this first approach is that no additional process steps are required - the same steps used to form the deep trenches 220, which may subsequently be filled, or not, are used to form the alignment structures 230.

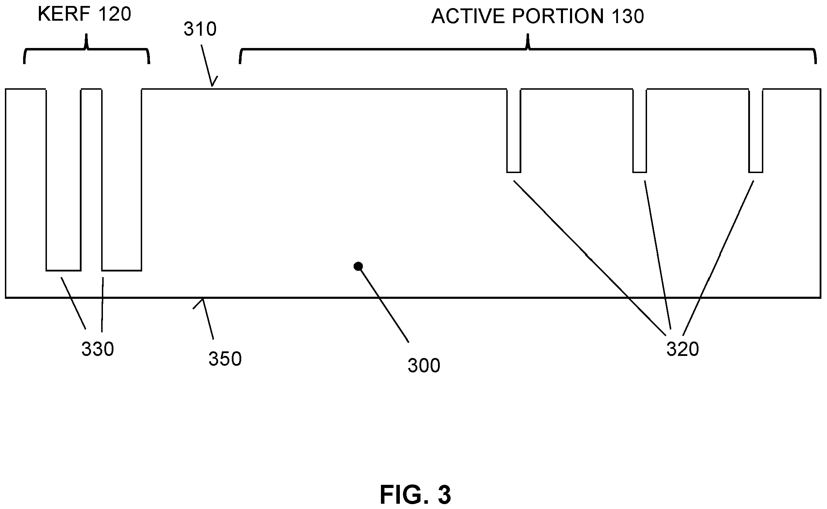

A second category of techniques applies when trenches are formed in the semiconductor wafer for non-alignment purposes, e.g., for reducing cross-talk, but these trenches are not deep enough to be visible from the opposite side of the wafer. An example of this approach is shown in Figure 3, where trenches 320 are formed in a first side 310 of semiconductor wafer 300. Because the trenches 320, which may or may not be subsequently filled, do not extend far enough into the semiconductor wafer 300 to be visible from the second side 350 using conventional illumination, a deeper trench is required to facilitate alignment of lithographic layers on the wafer's opposite side. In this case, the same process steps used to form the "normal" trenches 320 may be used again to form alignment marks 330. However, the trenches used for the alignment marks 330 can be formed with different dimensions, i.e., with a wider critical dimension, so that the same etching process used to form the normal trenches 320 will make the trenches used for the alignment marks 330 deeper. Again, these alignment marks 330 may be used for aligning additional lithographic layers on the same side of the wafer 300 in which the trenches are formed, although different alignment marks with narrower features might be used instead. In either case, the bottoms of the deep trenches formed for the alignment marks 330 extend deep enough into the semiconductor wafer 300 so that they can be used to align lithographic layers on the second side 350 of the wafer 300.

A third category of techniques may be used when silicon is deposited by an epitaxial deposition process, e.g., for forming a detector region in sensor devices. In this category of techniques, a first structure layer, which may be referred to as a "zero" layer," is formed before doing the epitaxial deposition, for subsequent use in aligning lithographic layers on both sides of the semiconductor wafer.

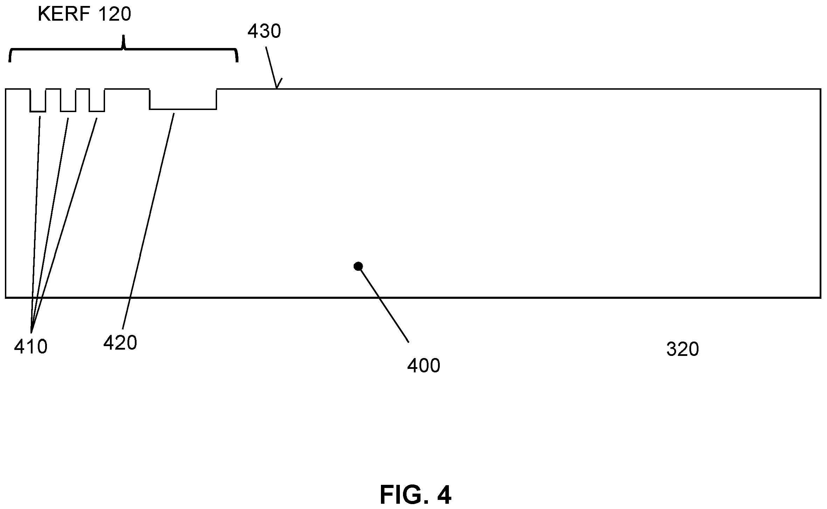

Figures 4-8 illustrate an example of this third category of techniques, which differs from the first two in that different alignment structures are required for aligning front-side and back-side lithographic layers. Figure 4 shows the formation of the "zero layer" mentioned above, which is formed before epitaxial deposition on a bulk semiconductor wafer 400. As shown in Figure 4, the "zero layer" may include a combination of narrow/smaller structures 410 formed in a first side 430 of the bulk semiconductor wafer 400, along with one or more wider/larger structures 420. Typically, although not necessarily, these structures are formed in a kerf portion of semiconductor wafer, away from an active portion 405.

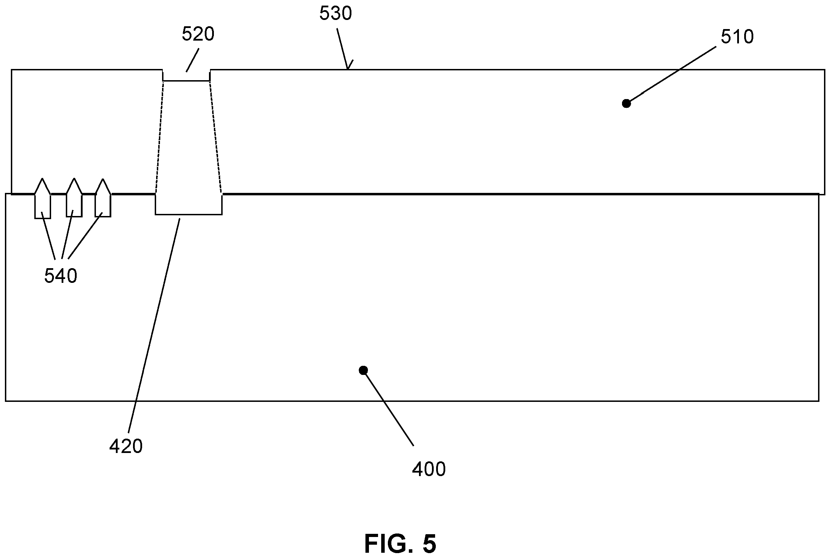

Next, as shown in Figure 5, an epitaxial layer 510 is deposited on the first side 430 of bulk semiconductor wafer 400, using any known techniques and equipment for epitaxial deposition. As seen in the figure, the larger structures 420, which may be relatively wide trenches, are formed in such a way that they are filled and overgrown by the epitaxial deposition. As seen in Figure 5, however, this results in topographical features 520, i.e., depressions, on the top side 530 of the epitaxial layer 510 - these top-side topographical features 520 are readily visible using normal illumination. Note that the top side 530 of the epitaxial layer at this point may be considered the "front side" of the semiconductor wafer 400, as augmented by the addition of epitaxial layer 510.

In contrast, consider the narrow structures 410. Here, the depositing of the epitaxial layer 510 does not fill the narrow structures 410, but simply overgrows them, leaving cavities 540. This overgrowth is not likely to leave readily visible topographical features on the top side of the semiconductor 500.

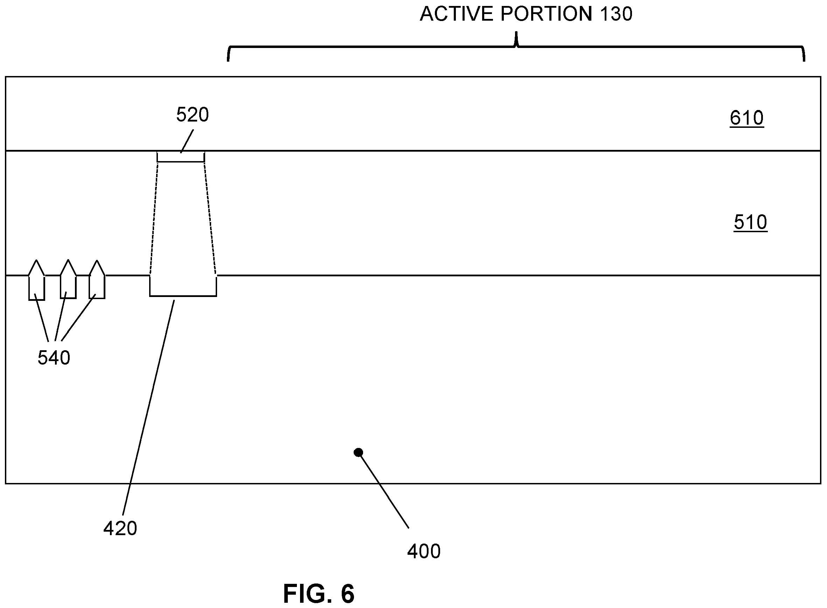

Figure 6 illustrates subsequent processing of the wafer front side. The top-side topographical features 520 formed when the larger structures 420 were filled by and overgrown with the epitaxial layer 510 act as top-side alignment marks, and can be used for aligning subsequent layers 610 on the same side of the semiconductor wafer 500 on which the epitaxial layer 510 is deposited. Each of these subsequent layers 610 are generally thin and thus effectively transparent, such that the topographical features 520 continue to be effective as front-side alignment marks. However, at this stage, the cavities 540 are not likely to be visible from the front side of the semiconductor wafer, and are not used for aligning front-side lithographic layers.

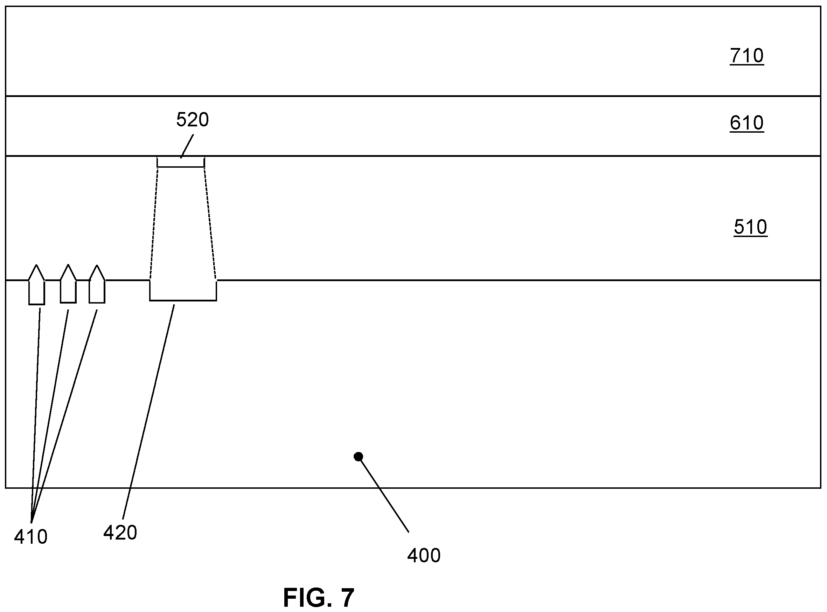

Later, however, back-side processing of the semiconductor wafer 500 will be performed, at which time the cavities 540 will be relevant. First, as shown in Figure 7, a second wafer 710 is directly bonded to the top-side of wafer 500, after the front-side processing of wafer 500 is completed. This is to provide mechanical rigidity, since the wafer 500 will subsequently be thinned, from the bottom, or back, side.

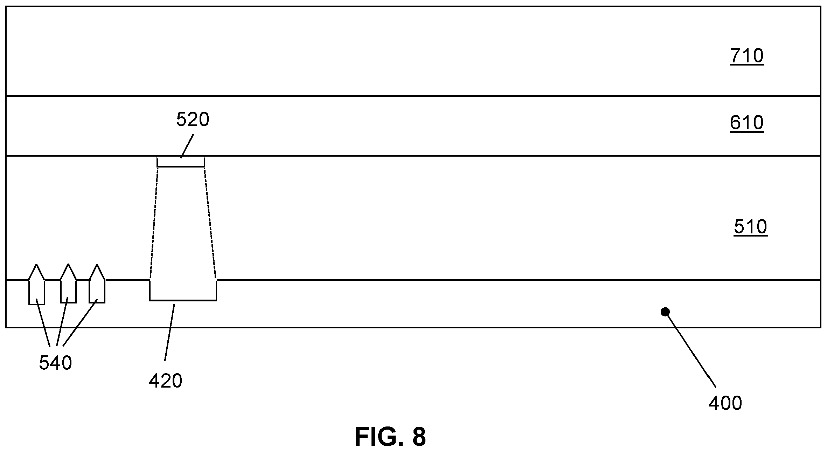

Figure 8 illustrates the result of thinning the wafer 500 from the bottom side. After this thinning the cavities 540 and the large structures 420 originally formed in the first side 430 of the semiconductor wafer 500 are close to the second side 810 of wafer 500, the second side 810 being the surface formed by the thinning. Because the large structures 420 are filled with the epitaxially deposited material of epitaxial layer 510, these large structures 420 are not likely to be readily visible from the bottom side of the semiconductor wafer 500, using normal illumination. However, if close enough, e.g., to within about 3 micrometers, the cavities 540 may be visible from the bottom side, under normal illumination, and may thus be used as alignment marks for aligning one or more lithographic layers applied to the bottom side. Note that in some embodiments, the thinning of semiconductor wafer 500 may be carried out to a point where the cavities 540 are actually opened to the bottom side, at which point the cavities 540 are easily visible.

In this third category of techniques, first and second alignment structures are used to align lithographic layers on the front and back sides of the semiconductor wafer, respectively. The back-side alignment is performed using the cavities 540, which were formed from the narrow structures 450 formed in the first side of the semiconductor wafer 400. The front-side alignment is performed using the topographical features 520, which correspond to the larger structures 410 formed in the first side of the semiconductor wafer 400. Because the narrow structures 450 and larger structures 410 are formed at the same time, the relative locations of these structures are controlled and known to a high degree of precision. Thus, the front-side and back-side alignments of lithographic layers can be performed very precisely as well, using standard alignment equipment without modification.

Each of the three categories of techniques described above may be used to produce a feature formed in one side of a semiconductor wafer that is visible, using conventional alignment systems, from the other side of the semiconductor. For alignment systems using wavelengths from 560 - 630 nm, it has been shown that the bottoms of trenches that extend into one side of an undoped silicon semiconductor wafer to within about 3 microns of the other side are visible from the other side. Thus, when the first and second categories of techniques described above are applied to a silicon wafer, the deep trenches used to form the alignment structures described above may be advantageously formed in the first side of the silicon wafer so that they extend to within about 3 microns of the second side, in some embodiments. In the third category of techniques, the second side of the semiconductor wafer is formed by thinning the semiconductor wafer, after processing on the first side of the semiconductor wafer. In this category of techniques, the narrow structures may be designed so that the cavities formed by the epitaxial overgrowth of these structures extend to within about 3 microns of the second side of the silicon wafer, after thinning of the wafer, in some embodiments. In other embodiments, these structures may be formed so that the subsequent thinning of the wafer opens up the cavities from the back side of the wafer.

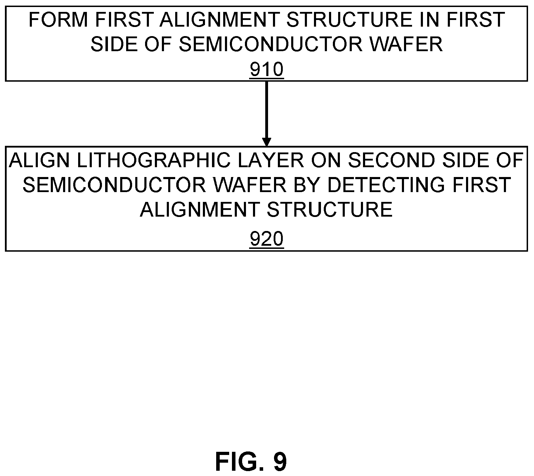

In view of the detailed examples discussed above, it will be appreciated that Figure 9 illustrates a generalized method of aligning a lithographic layer on a semiconductor wafer, covering embodiments in each of the three categories of techniques described above.

As shown at block 910, the illustrated method includes a step of forming, in a first side of the semiconductor wafer, a first alignment structure from one or more first trenches. These first trenches, which may take the form of grooves, slots, or other depressions intentionally formed in the surface of the first side of the semiconductor wafer.

As shown at block 920, the method further includes the step of aligning at least one lithographic layer on a second side of the semiconductor wafer by detecting the first alignment structure from the second side, using illumination in the visible spectrum.

The "first alignment structure" referred to here is formed in the first side of the semiconductor wafer, but is used to align one or more lithographic layers on the second side of the semiconductor. Thus, this first alignment structure may correspond to the alignment structure 230 shown in Figure 2, or the alignment structure 330 shown in Figure 3, or the alignment structure formed by cavities 540 in Figure 8. In the first two cases, the same alignment structure may also be used to align one or more lithographic layers on the first side of the semiconductor wafer, although different or additional ones may be used instead or in addition. In the third case, i.e., in embodiments like those shown in Figure 8, a different alignment structure is used to align lithographic layers on the first side of the wafer, as was discussed above in connection with Figure 6. Accordingly, the method shown in Figure 9 may additionally include the step of aligning one or more lithographic layers on the first side of the semiconductor wafer, using the alignment structure - this step is applicable when either of the first two categories of techniques described above are used.

In some embodiments, one or more of the first trenches are formed in a kerf portion of the semiconductor wafer using a same etching step used to form one or more trenches in an active portion of the semiconductor wafer. However, some or all of these first trenches may be formed in other portions of the semiconductor wafer, away from a kerf portion.

In some embodiments, these first trenches, which form the first alignment structure are formed to the same depth as the one or more trenches in the active portion of the semiconductor wafer. An example of these embodiments was illustrated in Figure 3 and discussed above. In other embodiments, the one or more first trenches have a wider critical distance than the one or more trenches in the active portion of the semiconductor wafer, such that the one or more first trenches are deeper than the one or more trenches in the active portion of the semiconductor wafer. An example of these embodiments was illustrated in Figure 4 and discussed above. In all of these embodiments, an advantage is that the same processing steps used to form one or more trenches in an active portion of the semiconductor wafer are used to form the trenches that form the first alignment structure.

In some embodiments, such as embodiments like the example shown in Figure 3, the one or more first trenches are formed to a depth reaching to within about 3 micrometers from the second side of the semiconductor wafer. In a silicon wafer, this will make these features visible from the second side, using illumination in the spectrum visible to the human eye. In other embodiments, the forming of the first trenches itself may not bring these trenches that close to the second side, the method may include an additional step of thinning the semiconductor wafer from a side opposite the first side, thereby forming the second side, prior to the alignment step shown in Figure 9. In some of these embodiments, this thinning may be performed so that the one or more first trenches reach to within about 3 micrometers from the second side of the semiconductor wafer.

In some embodiments, the method shown in Figure 9 may include the step of depositing an epitaxial layer on the first side of the semiconductor wafer, after forming the first alignment structure, but before performing the alignment step shown in the figure. This depositing of the epitaxial layer is done such that a bottom side of said epitaxial layer overgrows the one or more first trenches, leaving corresponding cavities between the semiconductor wafer and the epitaxial layer. An example of this was shown in Figure 5. In these embodiments, the method may further comprise thinning the semiconductor wafer from a side opposite the first side, after depositing the epitaxial layer, thereby forming the second side. An example of this is shown in Figure 8; this thinning may be performed after forming one or several process layers on or in the epitaxial layer formed on the first side of the semiconductor wafer (e.g., as shown in Figure 6), and after the direct bonding of a silicon layer to the top side of the semiconductor wafer plus epitaxial layer (e.g., as shown in Figure 7), for structural support. The thinning is performed to at least a thickness where the first alignment structure, which in this case comprises the cavities described above, is detectable from the second side of the semiconductor wafer using illumination in the visible spectrum. In these embodiments, the aligning step shown at block 920 of Figure 9 is performed after this thinning step, by detecting the corresponding cavities from the second side, using the illumination in the visible spectrum. In some embodiments, this may require that the thinning be performed so that the cavities reach to within about 3 micrometers from the second side of the semiconductor wafer. In some embodiments, the thinning may be carried out until one or more of the cavities are opened to the second side of the semiconductor wafer.

As was discussed above in connection with Figures 4-8, this third general approach utilizes an alignment structure other than the first alignment structure for performing alignment of lithographic layers on the first (or top) side of the semiconductor wafer. Thus, some embodiments of the method generally illustrated in Figure 9 include a step of forming a second alignment structure in the first side of the semiconductor wafer, prior to depositing the epitaxial layer, using one or more second trenches having a critical dimension greater than the one or more first trenches. These trenches are formed to have dimensions such that the subsequent depositing of the epitaxial layer fills the one or more second trenches, leaving a visible topology on a top side of the epitaxial layer, opposite the back side. An example of this was illustrated in Figure 5. In these embodiments, then, the method illustrated in Figure 9 may further comprise aligning one or more lithographic layers on the top side of the epitaxial layer by detecting the visible topology on the top side of the layer, using illumination in the visible spectrum.

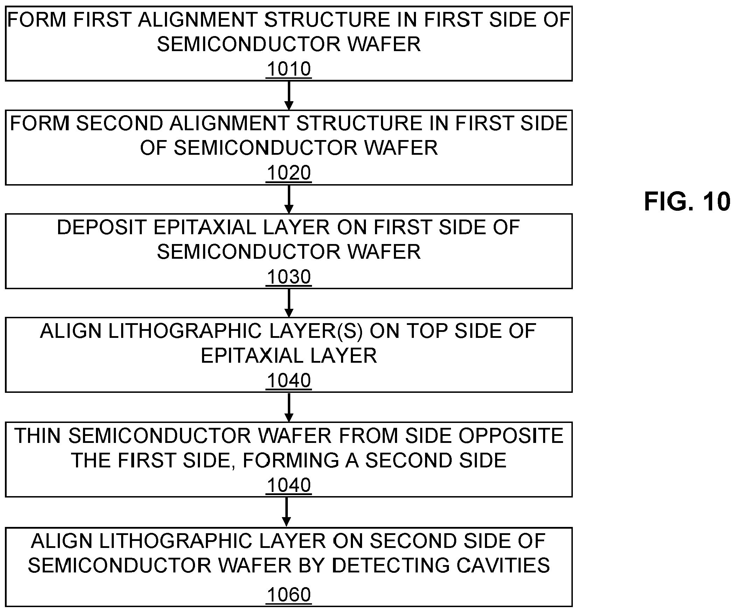

While the method illustrated in Figure 9 is general enough to apply to all of the three categories of techniques described above, the third category of techniques involves several intermediate steps performed between the forming of the first alignment structure on the first side of the semiconductor wafer, as shown at block 910, and the aligning of one or more lithographic layers on the second side of the semiconductor wafer, as shown at block 920. Figure 10 is a process flow diagram providing more details of an example method according to this third category.

The method illustrated in Figure 10 begins, as shown at block 1010, with forming, in a first side of the semiconductor wafer, a first alignment structure from one or more first trenches. These one or more first trenches in this case may correspond to the smaller structures 410 shown in Figure 4. The method further includes depositing an epitaxial layer on the first side of the semiconductor wafer, as shown at block 1030, after forming the first alignment structure. As previously discussed, the first alignment structure and the deposition are performed such that a bottom side of the epitaxial layer overgrows the one or more first trenches, leaving corresponding cavities between the semiconductor wafer and the epitaxial layer. The method further comprises, as shown at block 1050, thinning the semiconductor wafer from a side opposite the first side, after the depositing, thereby forming a second side. This thinning is performed to a thickness where the cavities are detectable from the second side of the semiconductor wafer using illumination in the visible spectrum. Again, the thinning might be performed so that the cavities reach to within about 3 micrometers from the second side of the semiconductor wafer, in some embodiments. In some other embodiments, the thinning might be performed to a point where one or more of the cavities are opened to the second side of the semiconductor wafer. As shown at block 1060, the method further comprises aligning at least one lithographic layer on the second side of the semiconductor wafer by detecting the cavities from the second side, using illumination in the visible spectrum.

The brief summary of Figure 10 in the preceding paragraph focused on the formation and use of the first alignment structure, which was formed in the first side of the semiconductor wafer but used for aligning one or more lithographic layers on the second side, just as was the case in the method shown in Figure 9. As was discussed above, an additional alignment structure may be formed in or on the first side of the semiconductor wafer, for use in aligning one or more lithographic layers applied to the same side of the semiconductor wafer on which the alignment structures are performed. Thus, in some embodiments of the method illustrated in Figure 10, the method comprises forming a second alignment structure in the first side of the semiconductor wafer, prior to depositing the epitaxial layer, using one or more second trenches having a critical dimension greater than the one or more first trenches, such that the depositing of the epitaxial layer fills the one or more second trenches. This leaves a corresponding visible topology on a top side of the epitaxial layer, opposite the back side, e.g., as shown in Figure 5.

This step of forming the second alignment structure is shown in Figure 10 at block 1020. While this step is shown below the forming of the first alignment structure, no particular ordering of the steps shown in blocks 1010 and 1020 is implied. In particular, it will be appreciated that the forming of the second alignment structure could be performed using the same processing steps used to form the first alignment structure.

Figure 10 also illustrates a step of aligning one or more lithographic layers on the top side of the epitaxial layer by detecting the visible topology on the top side of the layer, using illumination in the visible spectrum. This is shown at block 1040.

The techniques described above and illustrated in Figures 9 and 10 may be used in the fabrication of any of a wide variety of semiconductor devices, using various semiconductor materials. In some embodiments, for example, these techniques may comprise forming one or more image sensor devices in an active region of the semiconductor wafer, on the first side. As discussed above, an advantage of these techniques is that they may be used perform high-precision alignment between lithographic layers on the front and back sides of a semiconductor wafer, while avoiding the modification or replacement of conventional alignment systems using visible light. In at least some embodiments, the various alignment structures described herein can be formed using the very same processing steps used to form other structures in the semiconductor wafer, thus avoiding the addition of processing steps to the fabrication of semiconductor devices.

## Claims

1. A method of aligning a lithographic layer on a semiconductor wafer, the method comprising:
forming, in a first side of the semiconductor wafer, a first alignment structure from one or more first trenches;
aligning at least one lithographic layer on a second side of the semiconductor wafer by detecting the first alignment structure from the second side, using illumination in the visible spectrum.

2. The method of claim 1, further comprising aligning one or more lithographic layers on the first side of the semiconductor wafer, using the first alignment structure.

3. The method of claim 1 or 2, wherein the one or more first trenches are formed in a kerf portion of the semiconductor wafer using a same etching step used to form one or more trenches in an active portion of the semiconductor wafer, in particular, wherein the one or more first trenches are formed to the same depth as the one or more trenches in the active portion of the semiconductor wafer.

4. The method of claim 3, wherein the one or more first trenches have a wider critical distance than the one or more trenches in the active portion of the semiconductor wafer, such that the one or more first trenches are deeper than the one or more trenches in the active portion of the semiconductor wafer.

5. The method of one of the preceding claims, wherein said one or more first trenches are formed to a depth reaching to within about 3 micrometers from the second side of the semiconductor wafer.

6. The method of one of the preceding claims, wherein said method further comprises thinning the semiconductor wafer from a side opposite the first side, thereby forming the second side, prior to said aligning, in particular, wherein said thinning is performed so that the one or more first trenches reach to within about three micrometers from the second side of the semiconductor wafer.

7. The method of one of the preceding claims, wherein the method further comprises:
depositing an epitaxial layer on the first side of the semiconductor wafer, after said forming of the first alignment structure, such that a bottom side of said epitaxial layer overgrows the one or more first trenches, leaving corresponding cavities between the semiconductor wafer and the epitaxial layer; and
thinning the semiconductor wafer from a side opposite the first side, after said depositing, thereby forming the second side, the thinning being performed to at least a thickness where the first alignment structure is detectable from the second side of the semiconductor wafer using illumination in the visible spectrum;
wherein said aligning of the at least one lithographic layer is performed, after said thinning, by detecting the corresponding cavities from the second side, using the illumination in the visible spectrum.

8. The method of claim 7, wherein said thinning is performed so that the cavities reach to within about 3 micrometers from the second side of the semiconductor wafer.

9. The method of claim 7 or 8, wherein thinning the semiconductor wafer from the second side comprises thinning the semiconductor wafer at least until one or more of the cavities are opened to the second side of the semiconductor wafer.

10. The method of one of claims 7 to 9, further comprising:
forming a second alignment structure in the first side of the semiconductor wafer, prior to depositing the epitaxial layer, using one or more second trenches having a critical dimension greater than the one or more first trenches, such that the depositing of the epitaxial layer fills the one or more second trenches, leaving a visible topology on a top side of the epitaxial layer, opposite the back side;
aligning one or more lithographic layers on the top side of the epitaxial layer by detecting the visible topology on the top side of the layer, using illumination in the visible spectrum.

11. The method of one of the preceding claims, wherein the method comprises forming one or more image sensor devices in an active region of the semiconductor wafer, on the first side.

12. A method of aligning a lithographic layer on a semiconductor wafer, the method comprising:
forming, in a first side of the semiconductor wafer, a first alignment structure from one or more first trenches;
depositing an epitaxial layer on the first side of the semiconductor wafer, after said forming of the first alignment structure, such that a bottom side of said epitaxial layer overgrows the one or more first trenches, leaving corresponding cavities between the semiconductor wafer and the epitaxial layer;
thinning the semiconductor wafer from a side opposite the first side, after said depositing, thereby forming a second side, to at least a thickness where the cavities are detectable from the second side of the semiconductor wafer using illumination in the visible spectrum; and
aligning at least one lithographic layer on the second side of the semiconductor wafer by detecting the cavities from the second side, using illumination in the visible spectrum.

13. The method of claim 12, wherein said thinning is performed so that the cavities reach to within about 3 micrometers from the second side of the semiconductor wafer, in particular, wherein thinning the semiconductor wafer from the second side comprises thinning the semiconductor wafer at least until one or more of the cavities are opened to the second side of the semiconductor wafer.

14. The method of claim 12 or 13, wherein the method further comprises:
forming a second alignment structure in the first side of the semiconductor wafer, prior to depositing the epitaxial layer, using one or more second trenches having a critical dimension greater than the one or more first trenches, such that the depositing of the epitaxial layer fills the one or more second trenches, leaving a visible topology on a top side of the epitaxial layer, opposite the back side; and
aligning one or more lithographic layers on the top side of the epitaxial layer by detecting the visible topology on the top side of the layer, using illumination in the visible spectrum.

15. The method of one of claims 12 to 14, wherein the method comprises forming one or more image sensor devices in an active region of the semiconductor wafer, on the first side.
